# EUROPÄISCHE PATENTSCHRIFT

(11) **EP 2 010 928 B1**
(45) Veröffentlichungstag und Bekanntmachung des Hinweises auf die Patenterteilung: **26.08.2015**
(21) Anmeldenummer: 07728209.3
(22) Anmeldetag: 18.04.2007
(51) Int. Cl.: G01R 33/09

(54) **ORGANO-MAGNETORESISTIVER SENSOR UND VERWENDUNGEN DAZU**
ORGANO-MAGNETORESISTIVE SENSOR AND USES THEREOF
CAPTEUR ORGANO-MAGNÉTORÉSISTIF ET UTILISATIONS DE CELUI-CI

(30) Priorität: 26.04.2006 DE 102006019483
(43) Veröffentlichungstag der Anmeldung: 07.01.2009
(73) Patentinhaber: Siemens Aktiengesellschaft, 80333 München (DE)
(72) Erfinder: PÄTZOLD, Ralph, 91154 Roth (DE); SCHMID, Günter, 91334 Hemhofen (DE)
(86) Internationale Anmeldenummer: PCT/EP2007/053747
(87) Internationale Veröffentlichungsnummer: WO 2007/125036

(56) Entgegenhaltungen:
- EP-A- 1 302 778
- WO-A-2005/006461
- DE-U1-202005 012 932
- GB-A- 1 205 714
- US-A- 5 184 106

## Beschreibung

Die Erfindung betrifft einen organo-magnetoresistiven Sensor, Herstellungsverfahren und Verwendungen dazu. Diese werden beispielsweise als Sensoren zur Positions- und Strommessung oder zur Messung magnetischer Felder (Kompass) auf Basis magnetischer Schichtstrukturen (AMR/GMR/TMR) oder als Hallsensoren eingesetzt.

Bekannt sind Dünnschichtfolgen mit magnetoresistivem Effekt deren Empfindlichkeit gegenüber dem bei einschichtigen Systemen auftretenden klassischen "AMR" Effekt deutlich, insbesondere um mindestens eine Größenordnung erhöht ist. Hauptvertreter sind der so genannte GMR (Giant Magneto Resistance) Effekt und der TMR (Tunneling Magneto Resistance) Effekt.

Diese Effekte sind beispielsweise in dem Übersichtsartikel "Sandwiches mit riesigem Magnetwiderstand" von J. Wecker, R. Richter und R. Kinder erschienen in "Physik in unserer Zeit" 33. Jahrgang, 2002, Heft. Nr. 5, Seite 210 beschrieben.

Die Effekte werden in vielseitig anwendbaren Anordnungen genutzt. Besonders vielfältig einsetzbar sind dabei die Bauteile auf Basis von MR Effekten, weil z.B. Strom berührungslos und einfach messen können.

Nachteilig an den bisher bekannten Sensor-Anordnungen ist jedoch, dass sie nur kostenintensiv herstellbar sind und überwiegend aus spröden und/oder starren Materialien gemacht sind.

Aus der De 20 2005 012 932 U1 ist ein organischer Spin-Transistor bestehend aus einem Substrat, einer aktiven organischen Schicht, einem in Berührung mit der aktiven organische Schicht befindlichen Ladungsträger-injizierenden Kontakt, einem in Berührung mit der aktiven Schicht befindlichen elektrischen Kontakt und einer Gate-Elektrode, die durch eine elektrisch isolierende Schicht von der aktiven Schicht getrennt ist, bekannt. Dabei injiziert der Ladungsträgerinjizierende Kontakt spinpolarisierte Ladungsträger in die aktive organische Schicht, welche spinpolarisierte Ladungsträger transportieren kann. Die spinpolarisierten Ladungsträger werden über eine an der Gate-Elektrode anliegende Spannung kontrolliert.

Aufgabe der vorliegenden Erfindung ist es, eine Dünnschicht-Sensor-Anordnung mit magnetoresistivem Effekt zu schaffen, die kostengünstig, großflächig und/oder in Massenproduktion herstellbar ist und/oder biegsame oder flexible Schichten umfasst.

Lösung der Aufgabe und Gegenstand der Erfindung ist eine Anordnung zumindest ein als Transistor ausgestaltetes organisches elektronisches Dünnschichtbauteil mit zumindest drei Schichten und zumindest drei unterschiedlichen elektrischen Kontakten, wobei für eine Source-Elektrode (5) und eine Drain-Elektrode (6) das gleiche Material oder auch unterschiedliche Materialien verwendet werden können, und zumindest eine magnetfelderzeugende Vorrichtung umfassend, wobei die Anordnung derart ist, dass die magnetfelderzeugende Vorrichtung im organischen elektronischen Dünnschichtbauteil eine magnetoresistive Veränderung hervorruft, wobei als Materialien der Source-Elektrode (5) und der Drain-Elektrode (6) Palladium oder Gold oder Platin oder Kupfer oder Titan oder champhersulfonsäure-dotiertes Polyanilin oder polystyrolsulfonsäure-dotierte Polythiophene dienen. Außerdem ist Gegenstand der Erfindung die Verwendung einer solchen Anordnung zur Positionsmessung bei linearen Bewegungen, Drehbewegungen, Winkelmessungen, bei der Strommessung über das vom Strom hervorgerufene Magnetfeld und/oder Messungen von Magnetfeldern (Kompass).

Nach einer Ausführungsform der Erfindung ist zumindest eine der drei Schichten eine strukturierte Schicht, insbesondere eine elektrisch leitfähige Schicht, in der Source und Drain Elektroden strukturiert vorliegen.

Erfindungsgemäß ist das organische elektronische Dünnschichtbauteil ein Transistorelement. Dies ist besonders vorteilhaft, weil sich im Transistor die Anzahl und die Verteilung der Lochkonzentration durch die Source-/Drain-Spannung (Ladungsträgerinjektion) bzw. durch die Source-Gate-Spannung (Akkumulation der positiven Ladungsträger an der Halbleiter-Gatedielektrikumsgrenzfläche) steuern lassen, wodurch leicht verarbeitbare Messsignale erhalten werden. Die Verschiebung der Einsatzspannung, die Stromänderung im linearen oder Sättigungsbereich des Transistors sind Beispiele derartiger Messgrößen, die je nach Gatespannung am organischen Transistor eingestellt werden können.

Die Herstellung der organischen elektronischen Dünnschichtbauteile kann massenfertigungstauglich über Druckverfahren und sogar zumindest in Teilschritten im kontinuierlichen Druckverfahren erfolgen.

Das organische Elektronikbauteil umfasst zumindest drei Schichten, zwei elektrisch leitfähige und eine organische Dünnschicht. Dabei ist der Begriff "Schicht" nicht eng als gesonderte Schicht auszulegen, sondern es wird auf eine Funktionalität abgestellt. So kann durchaus eine der leitfähigen Schichten durch eine Dotierung einer mittleren Schicht ersetzbar sein, wobei dann bei der Zählung der Schichten im Dünnschichtbauteil an der Stelle nur eine Schicht gezählt werden kann, von der Funktionalität her aber sind in der Schicht doch zwei Schichten enthalten.

Jede der Schicht kann mit beliebigen Dopanden versetzt sein. Gedacht ist an Versetzungen mit Dopanden und Dotierungen wie sie beispielsweise in Applied Physics Letters 88, 152107 (2006) und in Journal of Applied Physics Vol. 94, Number 1, Seite 359 beschrieben sind.

Die organische(n) Dünnschicht(en) können entweder halbleitend, leitend oder isolierend sein. Dabei ist keiner der Begriffe streng begrenzt, sondern es gibt fließende Übergänge. Innerhalb eines organischen elektronischen Bauteils ist die Aufteilung jedoch klar, weil im Zusammenhang mit den übrigen Schichten eindeutig formuliert werden kann, welche der Schichten des organischen elektronischen Dünnschichtbauteils als halbleitend, leitend oder isolierend wirkt.

Jede der drei Schichten kann durch beliebige Hilfsschichten ergänzt sein, ebenso kann das organische elektronische Bauteil sowohl verkapselt als auch unverkapselt vorliegen.

Ein besonderer Vorteil der organischen Dünnschichten ist beispielsweise, dass die Schichten als dünne Folien aufgebracht werden können und, beispielsweise auf einem Foliensubstrat als Trägersubstanz aufgebracht, im Ganzen eine flexible und biegsame Anordnung ergeben, die auch großflächig herstellbar ist.

Die verwendeten Substratmaterialien sind sehr vielfältig. Beispielhaft seien hier flexible Folien aus Metall (Kupfer, Nickel, Gold, Eisenblech etc.), Kunststoffen (Polystyrol, Polyethylen, Polyester, Polyurethane, Polycarbonate, Polyacrylate, Polyimide, Polyether, Polybenzoxazole etc) oder Papier angeführt.

Als organische Halbleiter eignen sich die p-Halbleiter auf der Basis kondensierter Aromaten (Anthrazen, Tetrazen, Pentazen), Polythiophen (Poly-3-alkylthiophene, Polyvinylthiophen), Polypyrolle bzw. die metallorganischen Komplexe (Cu) des Phthalocyanins oder Porphyrins. Beispiele für n-Halbleiter sind perfluoriertes Tetracen, perfluoriertes Cu-Phthalocyanin oder Naphthalintetracarbonsäuredianhyrid bzw. dessen Derivate.

Die Dielektrika können sowohl anorganischer als auch organischer Natur sein. Z.B ist die Integration der anorganischen Dielektrika Siliziumdioxid oder Siliziumnitrid möglich.

Polystyrol, Polyethylen, Polyester, Polyurethane, Polycarbonate, Polyacrylate, Polyimide, Polyether, Polybenzoxazole sind wegen Ihrer potentiellen Druckbarkeit besonders geeignet. Aufgrund ihrer chemischen Stabilität und ihrer guten Verarbeitbarkeit eignen sich auch polymere Ferroelektrika auf der Basis fluorierter Polyene, wie Polyvinylidendifluorid, Polytrifluoretyle bzw. deren Co- oder Terpolymere besonders. Besonders geeignet sind auch Dielektrika auf der Basis von selbstorganisierenden Monolagen, da die Steuerspannungen hier nur im Bereich weniger Volt liegen.

Für die Herstellung der Elektroden und Verbindungsleitungen zwischen den Zellen und Transistoren eigenen sich Metalle (Pd, Au, Pt, Ni, Cu, Ti etc.) aufgrund ihres niedrigen ohmschen Widerstands. Für geringere Ansprüchen sind auch organische dotierte Halbleiter, wie champhersulfonsäure-dotiertes Polyanilin oder polystyrolsulfonsäure-dotierte Poylthiophene verwendbar.

Dabei kann der Kanal zwischen Source und Drain auch aus mehreren organischen halbleitenden Materialien aufgebaut sein. Über abschattende Resistmasken und Einstellung des Substrat-Quellenwinkels während der Abscheidung lassen sich Strukturen mit mindestens 2 organischen Halbleitern im Kanal erzeugen. Eine weitere Möglichkeit, die Lochinjektion zu steuern, besteht in der Nutzung unterschiedlicher Materialien oder technologischer Behandlung der Source und Drain-Elektroden (Beispiel: Source = Au, Drain = Al oder umgekehrt; Source/Drain = PEDOT, aber Source-Elektrode wird durch ein Fluorplasma behandelt).

Die Source/Drainelektroden können auch durch weitere Materialien wie beispielsweise durch Thiole, Phosphine oder Isonitrile funktionalisiert sein.

Der Übergang von einem organischen elektronischen Dünnschichtbauteil wie einer Diode, also einem Bauteil mit zwei unterschiedlichen elektrischen Kontakten als organisches Elektronikbauteil hin zu einem organischen Transistor mit zumindest drei unterschiedlichen elektrischen Kontakten ermöglicht eine um Größenordnungen höheren Freiheitsgrad bei der Gestaltung der Signalübertragung. Zudem wird die Form der Reaktion (z.B. Verschiebung der Einsatzspannung) in höheren Integrationslevel in die umgebende Elektronik (klassische Si-Technologie oder organischer Basis) erlaubt.

Unter dem Begriff "organische Materialien" sollen alle Arten von organischen, metallorganischen und/oder anorganischen Kunststoffen unter Ausnahme der klassischen auf Germanium, Silizium usw. basierenden Halbleitermaterialien verstanden werden. Es ist auch möglich, gefüllte Kunststoffe und Hybridmaterialien einzusetzen. Ferner soll der Begriff "organisches Material" ebenfalls nicht auf kohlenstoffhaltiges Material beschränkt sein, vielmehr sind auch Materialien wie Silicone möglich. Weiterhin sind neben polymeren und oligomeren Substanzen auch so genannte "small molecules" verwendbar.

Im Folgenden wird die Erfindung anhand dreier Figuren, die typische Transistorstrukturen, wie sie für die Erfindung geeignet sind, zeigen, näher erläutert.

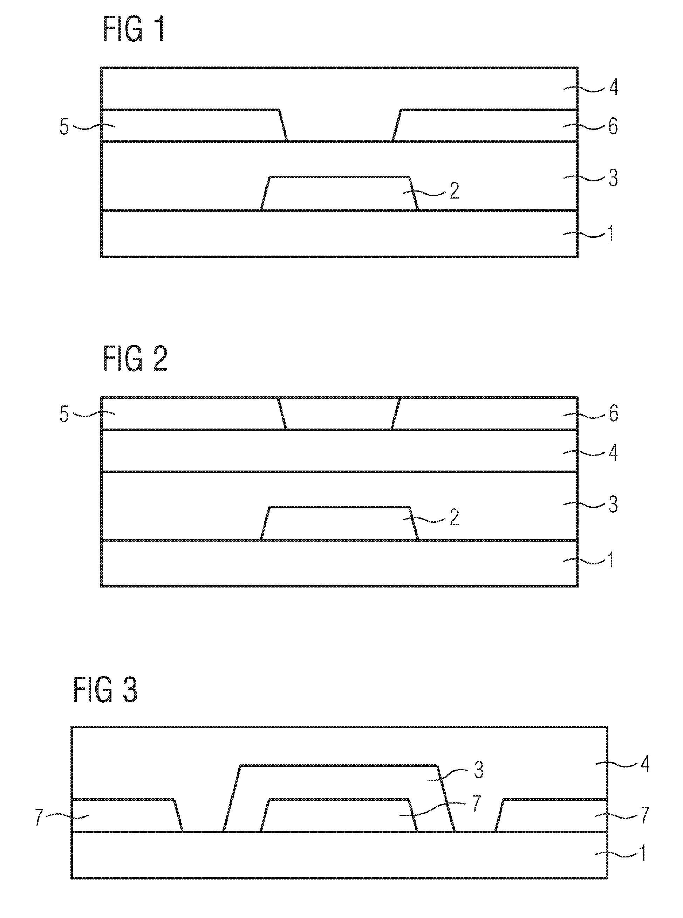

Figur 1 zeigt einen bottom-up Aufbau eines organischen Feld-Effekt-Transistors (OFET), bei dem auf einem Substrat 1 eine untere Elektrodenschicht 2, eingebettet in einen Isolator 3 zu erkennen ist. Über der Isolatorschicht 3 befindet sich eine Halbleiterschicht 4 aus organischem Material, in die die Source/Drain Elektroden 5,6 eingebettet sind. Der Stromkanal bildet sich dabei im Gate-Dielektrikum, der Isolatorschicht 3 zwischen Source und Drain aus.
Figur 2 zeigt prinzipiell den gleichen Aufbau, der bis auf die Tatsache, das Source und Drain Elektroden 5,6 nicht in die organische Halbleiterschicht eingebettet sind, sondern auf ihr liegen, sogar identisch ist.
Figur 3 schließlich zeigt einen anderen Aufbau: Auf dem Substrat 1 ist eine leitfähige und strukturierte Schicht 7 aufgebracht, in der verschiedene Elektroden Source/Drain 5,6 und Gate 2 ausgebildet sind. Die Gate 2 dieser Schicht ist selektiv von einer Isolatorschicht 3, dem Gate-Dielektrikum umgeben. Die gesamte leitfähige Schicht 7 mit allen Elektrodenstrukturen 5,6 und 2 ist in eine halbleitende organische Schicht 4 eingebettet.

Typische Strukturen für Transistoren auf organischer Basis in Bottom-Gate Architektur sind in Figuren 1 und 2 abgebildet. Figur 3 zeigt einen Transistor mit vereinfachter Elektrodenanordnung.

Die zu Fig. 1 inversen Transistoraufbauten (Top-Gate Anordnungen) können ebenfalls realisiert werden.

Zur Herstellung dieser OMR-Anordnung, insbesondere des zumindest einen organischen elektronischen Dünnschichtbauteils mit zumindest drei Schichten und zumindest drei unterschiedlichen elektrischen Kontakten kann beispielsweise wie folgt vorgegangen werden

### Beispiel 1:

Als Substrat für die Herstellung der organischen FeldeffektTransistoren wird eine flexible Polyethylennaphthalat-Folie verwendet. Nach dem Reinigen der Folie in Aceton und Isopropanol wird auf der Folie eine dünne Schicht Titan abgeschieden und mittels Photolithographie und nass-chemischem Ätzen in verdünnter Flusssäure strukturiert, um die Gate-Elektroden der Transistoren zu definieren. Nachfolgend wird mittels Kathodenstrahl-Zerstäubung eine dünne Schicht Siliziumdioxid als Gate-Dielektrikum für die Transistoren abgeschieden und mittels Photolithographie und nass-chemischem Ätzen strukturiert. Danach wird Palladium entweder durch thermisches Verdampfen, durch Elektronenstrahlverdampfen, oder mittels Kathodenstrahl-Zerstäubung abgeschieden und mittels Photolithographie und nass-chemischem Ätzen in einem stark verdünnten Gemisch aus Salzsäure und Salpetersäure geätzt, um die Source- und Drain-Kontakte der Transistoren zu definieren. Anschließend wird das Substrat für 5 Minuten in eine 5%ige Lösung von Triphenylphosphin in Xylol getaucht, um auf den Palladiumoberflächen eine Monolage Phosphin anzuscheiden; überschüssiges Phosphin wird mit Hexan abgespült. Nach dem Trocknen des Substrats wird mittels thermischen Verdampfens eine dünne Schicht Pentazen als organische Halbleiterschicht abgeschieden.

### Beispiel 2

Auf einer Glasplatte wird eine 30 nm dicke Titan- oder Aluminiumschicht aufgedampft oder gesputtert und photolithografisch strukturiert. Diese Schicht dient zur Herstellung der Gateelektroden und Teilen der Verbindungsleitungen zwischen den Transistoren. Auf diese Schicht werden 100 nm Polyvinylphenol aus Lösung aufgeschleudert und photolithografisch strukturiert. Die Durchbrüche in dieser Schicht dienen als "Vias" zwischen der Source-Drainlage und der Gatelage. Anschließend werden 30 nm Gold aufgedampft und photolithografisch strukturiert. Diese Schicht dient zur Herstellung der Source- und Drainelektroden und weiterer Verbindungsleitungen. Zur Vervollständigung der Transistorstruktur werden 30 nm Pentazen aufgedampft. Alternativ kann Pentazen auch aus einer Precursor-Verbindung abgeschieden werden. Um die empfindliche Halbleiterschicht gegenüber weiteren Prozessschritten zu schützen wird ein 2 µm dicke Parylenschicht abgeschieden und photolithographisch strukturiert.

Anstelle der Glasplatte können auch oxidierte Siliziumwafer, isolierend beschichtete Metallfolien oder Polymerfolien (Polyethylenterephthalat, Polyethylennaphthalat, Polyethylen, Polypropylen, Polystyrol, Polyimid, Polyetherketon etc.) verwendet werden. Ebenso werden cellulosebasierte Substrate eingesetzt.

Anstelle von Titan, Aluminium oder Goldelektroden können auch polymerbasierte PEDOT:PSS Elektroden verwendet werden. Im Allgemeinen bestehen diese aus einem dotierten organischen Halbleiter.

Anstelle von Polyvinylphenol können auch andere polymere Dielektrika verrwendet werden (Polyimid, Polyacrylate etc.) Bevorzugt werden diese auf Aluminium- oder Titan-Gateelektroden abgeschieden. Anorganische Dielektrika wie SiO2, SiN oder Al2O3 sind ebenfalls im Sinne der Erfindung.

Zu der in Beispiel 1 beschriebenen Transistorstruktur können noch eine oder mehrere Verdrahtungslagen hinzugefügt sein, um komplexere bzw. dichtere Layouts zu ermöglichen. Als Intermetalldielektrikum kann ebenfalls eine photolithografisch strukturierte Polyvinylphenolschicht dienen. Ebenso sind alle Dielelektrika aus Beispiel d. geeignet.

Wie bereits erwähnt, wird eine Massenproduktion insbesondere auch über Druckverfahren, eventuell solche, die einen kontinuierlichen Prozessschritt umfassen, durchgeführt werden.

Die Erfindung ermöglicht eine ganze Reihe von interessanten Verwendungen neuartiger Bauteile auf Basis von MR-Effekten.

## Patentansprüche

1. Anordnung zumindest ein als Transistor ausgestaltetes organisches elektronisches Dünnschichtbauteil mit zumindest drei Schichten (2, 3, 4, 5, 6; 3, 4, 7) und zumindest drei unterschiedlichen elektrischen Kontakten (2,5,6;7), wobei für eine Source-Elektrode (5) und eine Drain-Elektrode (6) das gleiche Material oder auch unterschiedliche Materialien verwendet werden können, und zumindest eine magnetfelderzeugende Vorrichtung umfassend, wobei die Anordnung derart ist, dass die magnetfelderzeugende Vorrichtung im organischen elektronischen Dünnschichtbauteil eine magnetoresistive Veränderung hervorruft,
**dadurch gekennzeichnet,**
**dass** als Materialien der Source-Elektrode (5) und der Drain-Elektrode (6) Palladium oder Gold oder Platin oder Kupfer oder Titan oder Aluminium oder champhersulfonsäure-dotiertes Polyanilin oder polystyrolsulfonsäure-dotierte Polythiophene dienen.

2. OMR- Anordnung nach Anspruch 1, wobei zumindest eine Schicht (5, 6; 7) der drei Schichten des organischen elektronischen Dünnschichtbauteils strukturiert ist.

3. Verwendung einer OMR-Anordnung nach einem der Ansprüche 1 und 2 zur Positionsmessung bei linearen Bewegungen, Drehbewegungen, Winkelmessungen, bei der Strommessung über das vom Strom hervorgerufene Magnetfeld und/oder Messungen von Magnetfeldern.

## Claims

1. Arrangement of at least one organic electronic thin-film component embodied as transistor having at least three layers (2, 3, 4, 5, 6; 3, 4, 7) and at least three different electrical contacts (2, 5, 6; 7), wherein the same material or else different materials can be used for a source electrode (5) and a drain electrode (6), and comprising at least one magnetic field-generating device, wherein the arrangement is such that the magnetic field-generating device brings about a magneto resistive change in the organic electronic thin-film component,
**characterized in that** palladium or gold or platinum or copper or titanium or aluminium or camphorsulphonic acid-doped polyaniline or polystyrenesulfonic acid-doped polythiophenes serve as materials of the source electrode (5) and of the drain electrode (6).

2. OMR arrangement according to Claim 1, wherein at least one layer (5, 6; 7) of the three layers of the organic electronic thin-film component is structured.

3. Use of an OMR arrangement according to either of Claims 1 and 2, for position measurement in the case of linear movements, rotational movements, angle measurements, in the case of current measurement by means of the magnetic field brought about by the current and/or measurements of magnetic fields.

## Revendications

1. Agencement comprenant au moins un composant organique électronique à couche mince, conformé en transistor et ayant au moins trois couches ( 2, 3, 4, 5, 6 ; 3, 4, 7 ) et au moins trois contacts ( 2, 5, 6 ; 7 ) électriques différents, le même matériau ou également des matériaux différents pouvant être utilisés pour une électrode ( 5 ) de source et une électrode ( 6 ) de drain et au moins un dispositif produisant un champ magnétique, l' agencement étant tel que le dispositif produisant un champ magnétique provoque une modification magnétorésistive dans le composant organique électronique à couche mince,
**caractérisé en ce que**
l'on se sert comme matériau de l' électrode ( 5 ) de source et de l' électrode ( 6 ) de drain de palladium ou d' or ou de platine ou de cuivre ou de titane ou d' aluminium ou de polyaniline dopée par de l' acide camphre sulfonique ou du polythiophène dopé par de l' acide polystyrène sulfonique.

2. Agencement OMR suivant la revendication 1, dans lequel au moins une couche ( 5, 6 ; 7 ) parmi les trois couches du composant organique électronique à couche mince est structurée.

3. Utilisation d'un agencement OMR suivant l'une des revendications 1 et 2
pour la mesure de position dans des déplacements linéaires, des mouvements de rotation, des mesures d' angle, dans la mesure du courant par l' intermédiaire du champ magnétique provoqué par le courant et/ou de mesures de champs magnétiques.
